# EUROPEAN PATENT SPECIFICATION

(11) **EP 2 625 721 B1**
(45) Date of publication and mention of the grant of the patent: **08.01.2020**
(21) Application number: 11767244.4
(22) Date of filing: 06.10.2011
(51) Int. Cl.: H01L 31/052, H02S 40/44, F28F 3/12, F28F 21/04, F28F 9/06

(54) **HIGH-EFFICIENCY PHOTOVOLTAIC PANEL**
HOCHEFFIZIENTES FOTOVOLTAIKMODUL
PANNEAU PHOTOVOLTAÏQUE À HAUT RENDEMENT

(30) Priority: 08.10.2010 IT MO20100282
(43) Date of publication of application: 14.08.2013
(73) Proprietor: Luxferov S.r.l., 42033 Carpineti (IT)
(72) Inventor: BELLONI, Mario, 42033 Carpineti (IT); PIFFERI, David, 41049 Sassuolo (IT)
(74) Representative: Corradini, Corrado
(86) International application number: PCT/EP2011/067512
(87) International publication number: WO 2012/045842

(56) References cited:
- EP-A2- 0 981 167
- WO-A1-2010/047577
- DE-A1- 3 314 637
- DE-A1- 19 851 230
- DE-U1-202009 010 235
- FR-A1- 2 924 864
- JP-A- 9 210 472
- US-A1- 2005 199 278

## Description

### Technical field

The present invention relates to a high-efficiency photovoltaic panel.

### Background Art

The use of photovoltaic technology is well-known for producing electricity by means of photovoltaic panels or modules.

Such panels are exposed directly to the sun's rays so as to be able to transform as much solar energy as possible into electricity in the best possible way. The sun's radiation, in addition to producing electricity, increases the temperature of the panel itself and, in particular, of the photovoltaic cells which tend to be less efficient, thus decreasing the overall yield of the panel.

For overcoming this problem temporary covering systems have been put on the market, such as for example blinds, which obscure the overheated panel until it cools naturally to preset temperatures.

This known solution, however, is not devoid of drawbacks. In fact, when the panel is covered, and therefore obscured, it is not capable of producing electricity. The production of electricity will therefore be intermittent so as to allow the cooling of the panel, and thus is not usable without an accumulator device.

A photovoltaic panel with a plurality of interspaces adapted for the passage of a fluid cooling medium and formed in the base of a photovoltaic panel is disclosed in document DE 20 2009 010235 U1.

### Disclosure of the Invention

The aim of the present invention is to eliminate the above-mentioned drawbacks in the background art, by providing a high-efficiency photovoltaic panel that makes it possible to maintain the inner temperature within an interval of acceptable values for good operation and, consequently, to optimize the overall yield of the panel.

Within this aim, an object of the present invention is to achieve the continuous operation thereof.

Another object of the present invention is to provide a simple structure, that is relatively easy and practical to implement, safe to use and effective in operation, and relatively low-cost.

This aim and this and other objects which will become more apparent hereinafter are achieved by a high-efficiency photovoltaic panel according to claim 1.

### Brief description of the drawings

Further characteristics and advantages of the present invention will become more apparent from the detailed description of a preferred, but not exclusive, embodiment of a high-efficiency photovoltaic panel, which is illustrated for the purposes of non-limiting example in the accompanying drawings wherein:

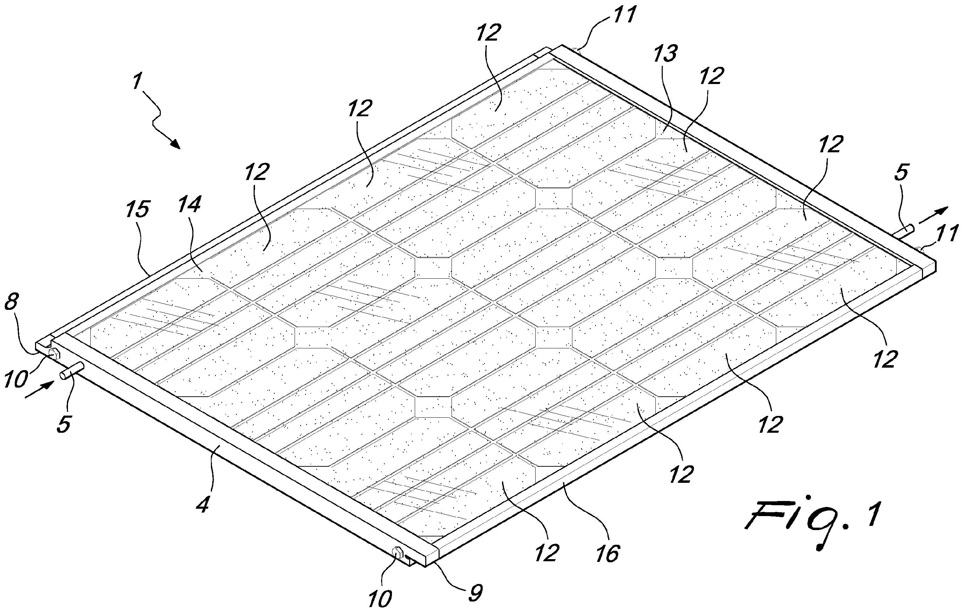

Figure 1 is a perspective view of a high-efficiency photovoltaic panel, according to the invention;

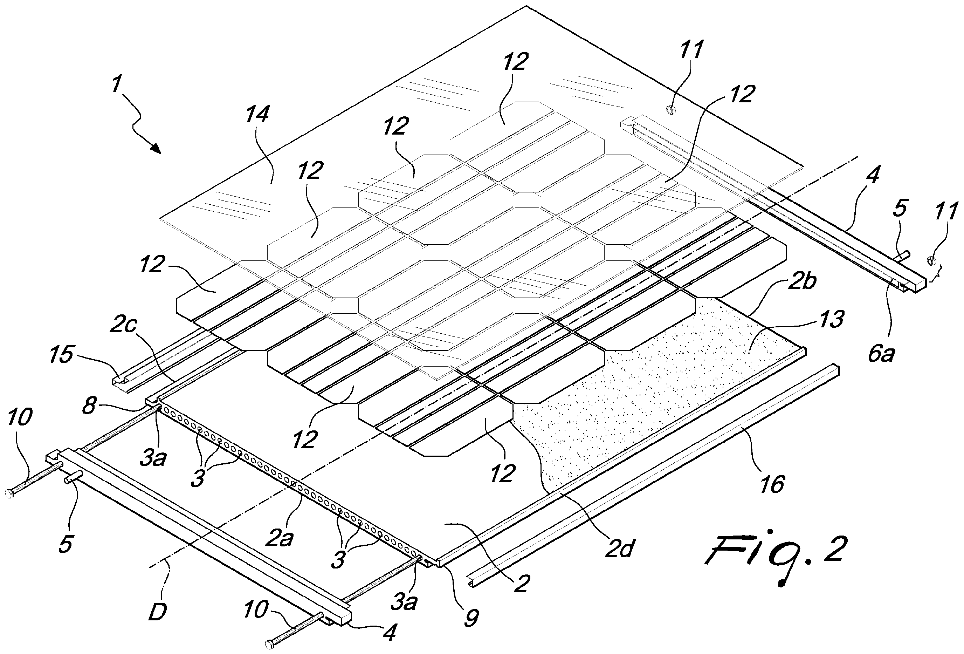

Figure 2 is an exploded view of the panel in Figure 1;

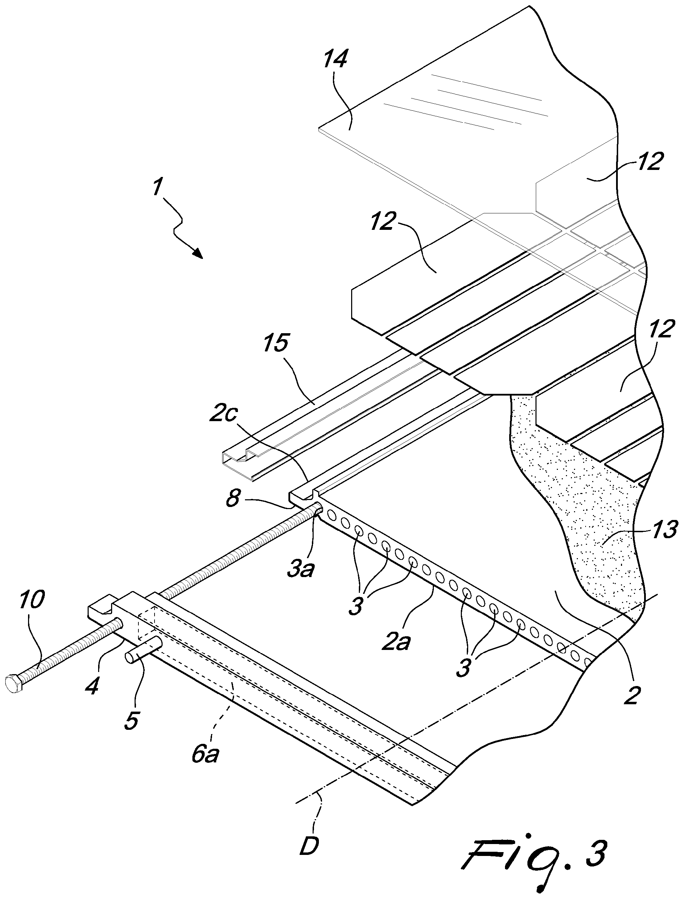

Figure 3 is an enlarged-scale view of a detail of Figure 2;
Figures 4 and 5 are views of respective embodiments of an end element of the panel, according to the invention.

### Ways of carrying out the Invention

With reference to the figures, a photovoltaic panel, according to the invention, is generally designated with the reference numeral 1. The panel 1 comprises a base 2 for supporting a plurality of photovoltaic cells 12 which are electrically connected to each other according to a technology known to the person skilled in the art, which is provided internally with at least one interspace 3 for the passage of a fluid cooling medium.

The base 2 is constituted by a substantially slab-like body that in plan view is polygonal in shape, preferably quadrangular, and forms a first resting surface, for laying the panel 1, and a second surface, on the side opposite to the first, on which the photovoltaic cells 12 are distributed.

Advantageously, the base 2 is made of ceramic material, or other thermally conducting material, and is preferably obtained by extrusion.

The photovoltaic panel 1 comprises, moreover, means 13 for protecting the photovoltaic cells 12 on which a covering plate 14 of glass is overlaid.

The protection means 13 can be of the conventional type, such as films of ethylene-vinyl acetate, or they can be constituted by a layer of semirigid material comprising at least one silicone polymer as disclosed in patent application no. MO2010A000271 in the name of this same Applicant.

The interspace 3 extends over the entire length of the base 2 along a direction D.

More preferably the base 2 is provided with a plurality of interspaces 3 which are not mutually connected.

In the embodiment shown, in particular, the interspaces 3 extend parallel to each other along the direction D and the open ends of each one of them faces two opposite sides 2a and 2b of the base 2.

It should be noted that the direction D, along which the interspaces 3 extend, coincides with the direction of extrusion of the base 2. In this way the interspaces 3 can be formed directly in the extrusion step of the base 2 in which they are incorporated.

The panel 1 comprises, moreover, at the opposite sides 2a and 2b, where the open ends of the interspaces 3 are facing, two end elements 4.

These end elements 4 cover all of the side 2a and 2b of the base 2, to which they are firmly coupled. The end element 4 comprises, on the side facing the base 2, at least one cavity for the fluid connection of the interspaces 3.

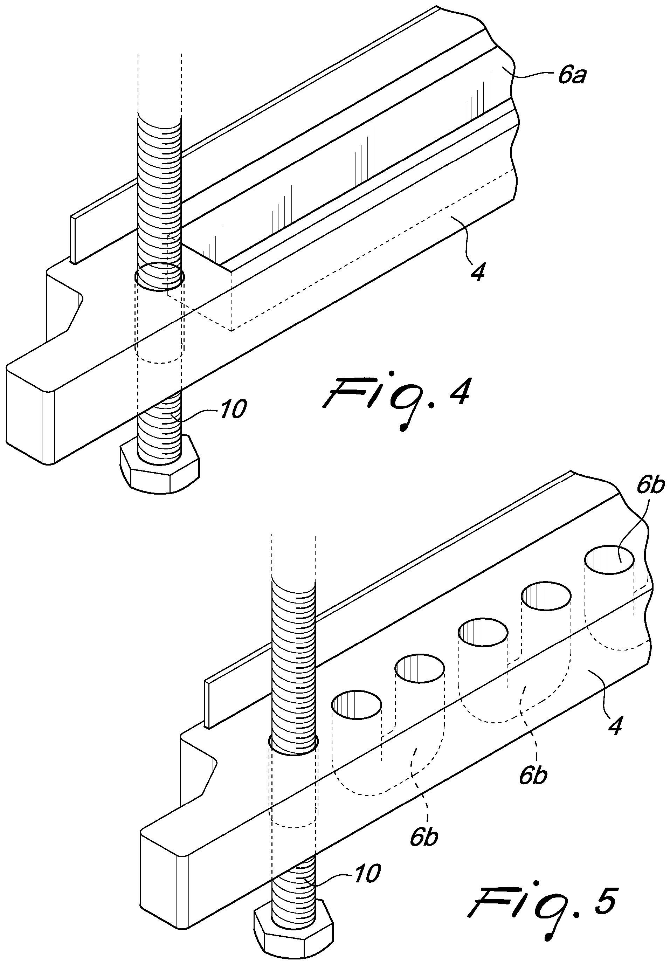

In a first embodiment, shown in Figure 4, each end element 4 comprises a single cavity 6a which is open at the side of the element facing the base 2.

In this way all the interspaces 3 are connected with the cavity 6a, and a passage of fluid cooling medium can be achieved along the base 2 along the direction D.

In a second embodiment, shown in Figure 5, each end element 4 comprises a plurality of U-shaped cavities 6b the open ends of which face the corresponding side 2a or 2b at two mutually adjacent interspaces 3. In this case the passage of fluid cooling medium is achieved along a winding route which is formed along the various interspaces 3 and the corresponding cavities 6b.

Each end element 4 has, moreover, at least one connecting element 5 of the hollow hydraulic type, of the type of a pipe coupling, communicating with the cavity 6a or one of the cavities 6b in order to permit the entry or exit of the fluid cooling medium into or out of the base 2.

In the proposed configuration for example a pipe coupling 5 is provided which is associated with each end element 4 at the side opposite from the side that is coupled to the base 2.

In use, one of the pipe couplings 5 is associated with a system for supplying the fluid cooling medium, while the the other is associated with means for draining and optionally recovering the fluid medium, which can be constituted, for example, by water or another cooling liquid, or by forced air.

The base 2 and the end elements 4 are mutually and firmly assembled thus ensuring a watertight seal according to a known method, for example by means of threaded bars 10 and self-locking nuts 11, thus exploiting the end interspaces 3 a of the base 2.

The base 2 comprises, finally, interlocking means for connection with an adjacent panel at least at two mutually opposite sides 2c and 2d.

In particular the connection means are constituted by shaped profiles of the male type 8, associated with the side 2c, and of the female type 9, associated with the side 2d, which are mutually complementary.

The profile of the male 8 or female 9 type can thus be coupled with a corresponding female or male profile of an adjacently-placed panel to form a paneling without discontinuities which makes it possible to cover and isolate the building structure below.

Once the panel 1 has been installed, its use is as follows.

As described above, the panel 1 is provided with a sort of circuit inside the base 2, made up of the interspaces and the cavities 6a or 6b formed in the end elements 4, for the passage of the fluid cooling medium.

The passage of the fluid cooling medium along this circuit makes it possible to remove heat from the photovoltaic cells 12 through the base 2.

This removal of heat will reduce the temperature of the panel 1, thus bringing the photovoltaic cells 12 to a lower temperature, offering a better working condition.

Different configurations of the cavities inside the end elements 4 offer different circuit configurations. For example one can have a first circuit with the cavity 6a where the fluid cooling medium passes through the base 2 following no particular route, whereas in the second possible configuration with a plurality of cavities 6b what is obtained is nothing less than a cooling coil in the base 2.

During the installation of the panels on site, the panel 1 can be accommodated beside identical panels, by juxtaposing the sides of the panels 2c and 2d which are provided with the connection means 8 and 9. These connection means enable a true connection, for example interlocking, so that a continuous surface of panels is obtained that are contiguous two by two. These connection means 8 and 9 can be covered by metallic profiles 15 and 16, for example aluminum profiles, which, in addition to protecting the connection means themselves from any accidental contact during installation, apply a slight pressure on the glass 14 on a side thereof, thus making it possible to immobilize the photovoltaic cells 12 in the protection means 13 with respect to the base 2.

In this configuration the exit point of the cooling circuit of a panel can be connected with the entry of the cooling circuit of the next panel, thus creating a single cooling circuit along the line of connected panels 1.

In practice it has been found that the panel according to the invention achieves the intended aim and objects, and particular attention is drawn to the fact that the panel succeeds in producing electricity without interruptions or variations in yield owing to the overheating of the photovoltaic cells.

The invention, thus conceived, is susceptible of numerous modifications and variations, all of which are within the scope of the appended claims.

Moreover, all the details may be substituted by other, technically equivalent elements.

In practice the materials employed, as well as the contingent dimensions and shapes, may be any according to requirements but without for this reason extending beyond the scope of protection of the following claims.

Where technical features mentioned in any claim are followed by reference signs, those reference signs have been included for the sole purpose of increasing the intelligibility of the claims and accordingly, such reference signs do not have any limiting effect on the interpretation of each element identified by way of example by such reference signs.

## Claims

1. A high-efficiency photovoltaic panel (1), comprising a base (2) made of ceramic material for supporting a plurality of photovoltaic cells (12), wherein the base (2) comprises internally a plurality of interspaces (3) adapted for the passage of a fluid cooling medium which are not mutually connected and wherein said interspaces (3) extend so as to be mutually substantially parallel along said direction (D) and have corresponding ends which are open at two mutually opposite sides (2a and 2b) of said base (2); and two end elements (4) which are associated with said base (2) at said mutually opposite sides (2a and 2b) for the connection of said interspaces (3), **characterized in that** each one of said end elements (4) has a single cavity (6a) that faces the corresponding side (2a or 2b) of said base (2) for the interconnection of all said interspaces (3), and one connecting element of the hydraulic type (5) for the inflow/outflow of said fluid cooling medium.

2. The photovoltaic panel (1) according to claim 1, **characterized in that** said at least one interspace (3) extends over the entire length of said base (2) along a direction (D).

3. The photovoltaic panel (1) according to one or more of the preceding claims, **characterized in that** it comprises interlocking connection means (8 and 9) which are associated with said base (2) at at least one pair of mutually opposite sides (2c and 2d) for connection to adjacent panels (1) and **in that** said connection means (8 and 9) are covered by metal profiles (15 and 16).

4. The photovoltaic panel (1) according to one or more of the preceding claims, **characterized in that** said base (2) has a substantially slab-like quadrangular plan shape and has a first pair of mutually opposite sides (2a and 2b) facing said interspaces (3) and a second pair of mutually opposite sides (2c and 2d) which are associated with said connection means (8 and 9).

5. The photovoltaic panel (1) according to one or more of the preceding claims, **characterized in that** said base (2) is made of ceramic material and can be obtained by extrusion.

6. The photovoltaic panel (1) according to claim 5, **characterized in that** said direction (D) is substantially parallel to the direction of extrusion of said base (2).

## Patentansprüche

1. Hocheffizientes Photovoltaikpaneel (1), umfassend eine Basis (2) aus Keramikmaterial zum Tragen einer Vielzahl von Photovoltaikzellen (12), wobei die Basis (2) im Inneren eine Vielzahl von Zwischenräumen (3) umfasst, die für das Durchströmen eines Fluidkühlmediums ausgelegt sind, die nicht miteinander verbunden sind, und wobei sich die Zwischenräume (3) so erstrecken, dass sie im Wesentlichen entlang der Richtung (D) zueinander parallel sind und entsprechende Enden aufweisen, die an zwei einander gegenüberliegenden Seiten (2a und 2b) der Basis (2) offen sind; und zwei Endelemente (4), die an den einander gegenüberliegenden Seiten (2a und 2b) zur Verbindung der Zwischenräume (3) an der Basis (2) angeschlossen sind, **dadurch gekennzeichnet, dass** jedes der Endelemente (4) einen einzigen Hohlraum (6a) aufweist, der zur gegenseitigen Verbindung aller Zwischenräume (3) der entsprechenden Seite (2a oder 2b) der Basis (2) zugewandt ist, und ein Verbindungselement vom Hydrauliktyp (5) für den Einfluss/Abfluss des Fluidkühlmediums.

2. Photovoltaikpaneel (1) nach Anspruch 1, **dadurch gekennzeichnet, dass** sich mindestens ein Zwischenraum (3) über die gesamte Länge der Basis (2) entlang einer Richtung (D) erstreckt.

3. Photovoltaikpaneel (1) nach einem oder mehreren der vorstehenden Ansprüche, **dadurch gekennzeichnet, dass** es Interlock-Verbindungsmittel (8 und 9) umfasst, die an zumindest einem Paar von einander gegenüberliegenden Seiten (2c und 2d) zur Verbindung mit benachbarten Paneelen (1) an der Basis (2) angeschlossen sind, und dass die Verbindungsmittel (8 und 9) von Metallprofilen (15 und 16) bedeckt sind.

4. Photovoltaikpaneel (1) nach einem oder mehreren der vorstehenden Ansprüche, **dadurch gekennzeichnet, dass** die Basis (2) eine im Wesentlichen plattenähnliche viereckige ebene Form aufweist und ein erstes Paar von einander gegenüberliegenden Seiten (2a und 2b), das den Zwischenräumen (3) zugewandt ist, und ein zweites Paar von einander gegenüberliegenden Seiten (2c und 2d) aufweist, die an den Verbindungsmitteln (8 und 9) angeschlossen sind.

5. Photovoltaikpaneel (1) nach einem oder mehreren der vorstehenden Ansprüche, **dadurch gekennzeichnet, dass** die Basis (2) aus Keramikmaterial besteht und mittels Extrusion erhalten werden kann.

6. Photovoltaikpaneel (1) nach Anspruch 5, **dadurch gekennzeichnet, dass** die Richtung (D) im Wesentlichen parallel zur Extrusionsrichtung der Basis (2) ist.

## Revendications

1. Un panneau photovoltaïque à haut rendement (1), comprenant une base (2) faite en matériau céramique pour supporter une pluralité de cellules photovoltaïques (12), dans lequel la base (2) comprend à l'intérieur une pluralité d'espaces intermédiaires (3) conçus pour le passage d'un milieu de refroidissement fluide qui ne sont pas connectés entre eux et dans lequel lesdits espaces intermédiaires (3) s'étendent de manière à être substantiellement parallèles les uns aux autres le long de ladite direction (D) et ont des extrémités correspondantes qui sont ouvertes au niveau de deux côtés opposés l'un à l'autre (2a et 2b) de ladite base (2) ; et deux éléments d'extrémité (4) qui sont associés à ladite base (2) au niveau desdits côtés opposés l'un à l'autre (2a et 2b) pour la connexion desdits espaces intermédiaires (3), **caractérisé en ce que** chacun desdits éléments d'extrémité (4) a une cavité unique (6a) qui fait face au côté correspondant (2a ou 2b) de ladite base (2) pour l'interconnexion de tous lesdits espaces intermédiaires (3), et un élément de raccord du type hydraulique (5) pour l'entrée/la sortie dudit milieu de refroidissement.

2. Le panneau photovoltaïque (1) selon la revendication 1, **caractérisé en ce que** ledit au moins un espace intermédiaire (3) s'étend sur toute la longueur de ladite base (2) le long d'une direction (D).

3. Le panneau photovoltaïque (1) selon une ou plusieurs des revendications précédentes, **caractérisé en ce qu'**il comprend des moyens de connexion par emboîtement (8 et 9) qui sont associés à ladite base (2) au niveau d'au moins une paire de côtés opposés l'un à l'autre (2c et 2d) pour une connexion à des panneaux adjacents (1) et **en ce que** lesdits moyens de connexion (8 et 9) sont recouvert par des profilés métalliques (15 et 16).

4. Le panneau photovoltaïque (1) selon une ou plusieurs des revendications précédentes, **caractérisé en ce que** ladite base (2) a un profil plan quadrangulaire substantiellement en forme de bloc et a une première paire de côtés opposés l'un à l'autre (2a et 2b) faisant face auxdits espaces intermédiaires (3) et une deuxième paire de côtés opposés l'un à l'autre (2c et 2d) qui sont associés auxdits moyens de connexion (8 et 9).

5. Le panneau photovoltaïque (1) selon une ou plusieurs des revendications précédentes, **caractérisé en ce que** ladite base (2) est faite en matériau céramique et peut être obtenue par extrusion.

6. Le panneau photovoltaïque (1) selon la revendication 5, **caractérisé en ce que** ladite direction (D) est substantiellement parallèle à la direction d'extrusion de ladite base (2).
